# EUROPÄISCHE PATENTANMELDUNG

(11) **EP 4 446 194 A1**
(43) Veröffentlichungstag der Anmeldung: **16.10.2024**
(21) Anmeldenummer: 24168679.9
(22) Anmeldetag: 05.04.2024
(51) Int. Cl.: B61L 19/06, B61L 27/53, B61L 27/60, B61L 7/10, G01R 31/58, H04B 3/46, H04B 3/50

(54) **PRÜFSCHALTUNGSANORDNUNG**

(30) Priorität: 11.04.2023 DE 102023109028
(71) Anmelder: Scheidt & Bachmann GmbH, 41238 Mönchengladbach (DE)
(72) Erfinder: Priebe, Dr.-Ing. Andreas, 58089 Hagen (DE)
(74) Vertreter: Cohausz & Florack

(57) **Zusammenfassung**

Die Anmeldung betrifft eine Prüfschaltungsanordnung (100, 200) für ein System (240, 340, 440, 540) mit einem zwischen einer ersten Vorrichtung (242, 342, 442, 542) des Systems (240, 340, 440, 540) und einer zweiten Vorrichtung (244, 344, 444, 544) des Systems (240, 340, 440, 540) angeordneten Antivalenz-Übertragungspfad (246) mit einem ersten Übertragungsweg (248) und einem zweiten Übertragungsweg (250), wobei der Antivalenz-Übertragungspfad (246) eingerichtet ist zum Übertragen eines antivalenten Signalbilds von der ersten Vorrichtung (242, 342, 442, 542) zu der zweiten Vorrichtung (244, 344, 444, 544), umfassend eine in dem Antivalenz-Übertragungspfad (246) anordenbare Signalbildwechselschaltung (102, 202, 302, 402, 502), eine mit einem in Übertragungsrichtung hinter der Signalbildwechselschaltung (102, 202, 302, 402, 502) angeordneten Kopplungsbereich (256) des Antivalenz-Übertragungspfads (246) koppelbare Signalsensoreinrichtung (104, 204), und eine mit der Signalbildwechselschaltung (102, 202, 302, 402, 502) und der Signalsensoreinrichtung (104, 204) verbundene Auswerteeinrichtung (108, 208), wobei die Auswerteeinrichtung (108, 208) eine Signalbildwechselsteuerung (114, 214) umfasst, eingerichtet zum Ansteuern der Signalbildwechselschaltung (102, 202, 302, 402, 502) mit mindestens einem Schaltbefehl während einer Prüfphase, wobei die Auswerteeinrichtung (108, 208) ein Prüfmodul (116, 216) umfasst, eingerichtet zum Prüfen der Funktionsfähigkeit des Systems (240, 340, 440, 540) während der Prüfphase, basierend auf dem mindestens einen Schaltbefehl und mindestens einem durch die Signalsensoreinrichtung (104, 204) erfassten Signalbild.

## Beschreibung

Die Anmeldung betrifft eine Prüfschaltungsanordnung für ein (sicherheitsrelevantes) System mit einem zwischen einer ersten Vorrichtung des Systems und einer zweiten Vorrichtung des Systems angeordneten Antivalenz-Übertragungspfad mit einem ersten Übertragungsweg und einem zweiten Übertragungsweg, wobei der Antivalenz-Übertragungspfad eingerichtet ist zum Übertragen eines antivalenten Signalbilds von der ersten Vorrichtung zu der zweiten Vorrichtung. Darüber hinaus betrifft die Anmeldung ein System, ein Verfahren und eine Verwendung.

Aus dem Stand der Technik sind Systeme mit einer ersten Vorrichtung und einer zweiten Vorrichtung bekannt, bei dem Signalwerte von der ersten Vorrichtung an die zweite Vorrichtung übertragen werden. Insbesondere bei sicherheitsrelevanten Anwendungen ist es bei einem solchen System erforderlich, das ein übertragener Signalwert bzw. ein übertragener Signalzustand der ersten Vorrichtung nicht verfälscht wird. Mit anderen Worten, es muss sichergestellt werden, dass der von der ersten Vorrichtung ausgesendete Signalwert auch tatsächlich durch die zweite Vorrichtung detektiert wird. Wenn beispielsweise als Signalwert ein logischer Wert 1 ausgesendet wird, muss sichergestellt sein, dass die zweite Vorrichtung auch tatsächlich einen logischen Wert 1 detektiert (und nicht einen logischen Wert 0).

Ein Beispiel eines Systems, an das hohe Sicherheitsanforderungen gestellt werden, ist ein Schienensystem bzw. Gleissystem, bei dem Signalwerte von einer ersten Vorrichtung in Form eines ersten Stellwerks zu einer zweiten Vorrichtung in Form eines zweiten Stellwerks übertragen werden. Ein Stellwerk dient insbesondere in bekannter Weise zum Stellen von Weichen des Schienensystems. Da in bekannter Weise bei einem derartigen System eine falsche Detektion eines übertragenen Signalwerts zu erheblichen Problemen/Störungen führen kann, ist es bei einem solchen System, aber auch bei anderen Systemen mit hohen Sicherheitsanforderungen, üblich, die Übertragung eines Signalwerts von der ersten Vorrichtung an die zweite Vorrichtung abzusichern.

Insbesondere zur Erhöhung der Sicherheit kann die Übertragung eines Signalwerts in Form eines Signalbilds erfolgen, insbesondere eines antivalenten Signalbilds, das mittels einem zwischen der ersten Vorrichtung des Systems und der zweiten Vorrichtung des Systems angeordneten Antivalenz-Übertragungspfad mit einem ersten Übertragungsweg und einem zweiten Übertragungsweg übertragen wird. Der Antivalenz-Übertragungspfad ist also eingerichtet zum Übertragen eines antivalenten Signalbilds von der ersten Vorrichtung zu der zweiten Vorrichtung.

Ein übertragenes Signalbild wird durch die zweite Vorrichtung insbesondere nur dann als gültiges Signalbild erkannt, wenn sich der Signalwert des ersten Übertragungswegs von dem Signalwert des zweiten Übertragungswegs unterscheidet. Mit anderen Worten, gültige Signalzustände sind dabei nur solche, bei denen genau einer der genau zwei Übertragungswege den Signalwert überträgt. Wenn beispielsweise gewünscht ist, dass ein Signalwert einen logischen Wert 1 hat, dann werden über den ersten Übertragungsweg ein erstes Teilsignal mit dem logischen Wert 1 und über den zweiten Übertragungsweg ein zweites Teilsignal mit dem logischen Wert 0 übertragen. Es wird also das antivalente Signalbild (1,0) übertragen. Wenn der Signalwert gewechselt wird, also ein logischer Wert 0 übertragen wird, dann werden über den ersten Übertragungsweg ein erstes Teilsignal mit dem logischen Wert 0 und über den zweiten Übertragungsweg ein zweites Teilsignal mit dem logischen Wert 1 übertragen. Es wird also das antivalente Signalbild (0,1) übertragen.

Aus dem Stand der Technik ist es bekannt, dass ein Übertragungsfehler erkannt wird, wenn die zweite Vorrichtung ein nicht-antivalentes Signalbild (z.B. (1,1) oder (0,0)) empfängt. Ein Übertragungsfehler kann beispielsweise dazu führen, dass ein Teilsignal mit dem logischen Wert 1 von der zweiten Vorrichtung, die dieses Teilsignal empfängt, als logischer Wert 0 erkannt wird. Ein Kurzschluss in dem Antivalenz-Übertragungspfad, insbesondere dem ersten Übertragungsweg, kann beispielsweise dazu führen, dass ein Teilsignal mit dem logischen Wert 1 von der zweiten Vorrichtung erkannt wird, obwohl kein Teilsignal bzw. ein Teilsignal mit dem logischen Wert 0 gesendet wurde.

Wie beschrieben wurde, erfolgt die Prüfung der Funktionsfähigkeit des Systems und insbesondere des Antivalenz-Übertragungspfads im Stand der Technik durch die normale Funktion bzw. in dem Normalbetrieb des Systems, in dem sich die Signalbilder bzw. Teilsignale an der sendenden (ersten) Vorrichtung insbesondere bei einer Änderung mindestens eines Betriebszustands ändern. Wird dieser Wechsel durch die zweite Vorrichtung richtig detektiert, wird eine fehlerfreie Funktionsfähigkeit des Systems im Stand der Technik angenommen.

Beim Stand der Technik ist es insbesondere problematisch, dass bis zur Erkennung einer fehlerhaften Funktionsfähigkeit des Systems und insbesondere des Antivalenz-Übertragungspfads eine erhebliche Zeitdauer vergehen kann. Mit anderen Worten, die Fehleroffenbarungszeit kann sehr hoch sein beim Stand der Technik. Insbesondere bei dem beschriebenen beispielhaften Schienensystem, aber auch bei anderen Systemen, kann es vorkommen, dass in der ersten Vorrichtung, also der sendenden Vorrichtung kein Betrieb durchgeführt wird oder sich ein Betriebszustand aus anderen Gründen über eine längere Zeitdauer (z.B. zwischen 1 Monat bis hin zu mehr als 1 Jahr) nicht ändert. Dann kann die zweite Vorrichtung eine Funktionsfähigkeit des Systems aufgrund eines fehlenden Zustandswechsels während der genannten Zeitdauer nicht prüfen. Dies führt dazu, dass eine fehlerhafte Funktionsfähigkeit bzw. ein beschriebener Übertragungsfehler erst mit einer deutlichen Verzögerung detektierbar ist. Eine zeitnahe Behebung eines Übertragungsfehlers ist damit auch nicht möglich. Vielmehr kommt es aufgrund der verzögerten Fehlerdetektion im Betrieb, beispielsweise des Schienensystems, zu weiteren Störungen.

Daher liegt der Anmeldung die Aufgabe zugrunde, eine Möglichkeit zu schaffen, bei einem System mit einem zwischen einer ersten Vorrichtung des Systems und einer zweiten Vorrichtung des Systems angeordneten Antivalenz-Übertragungspfad mit einem ersten Übertragungsweg und einem zweiten Übertragungsweg, wobei der Antivalenz-Übertragungspfad eingerichtet ist zum Übertragen eines antivalenten Signalbilds von der ersten Vorrichtung zu der zweiten Vorrichtung, die Nachteile des Stands der Technik zu reduzieren und insbesondere die Fehlerdetektionszeit zu verkürzen.

Die Aufgabe wird gemäß einem ersten Aspekt der Anmeldung gelöst durch eine Prüfschaltungsanordnung nach Anspruch 1 für ein System mit einem zwischen einer ersten Vorrichtung des Systems und einer zweiten Vorrichtung des Systems angeordneten Antivalenz-Übertragungspfad mit einem ersten Übertragungsweg und einem zweiten Übertragungsweg. Der Antivalenz-Übertragungspfad ist eingerichtet zum Übertragen eines antivalenten Signalbilds von der ersten Vorrichtung zu der zweiten Vorrichtung. Die Prüfschaltungsanordnung umfasst eine in dem Antivalenz-Übertragungspfad anordenbare Signalbildwechselschaltung. Die Prüfschaltungsanordnung umfasst eine mit einem in Übertragungsrichtung (des Signalbilds) hinter der Signalbildwechselschaltung angeordneten Kopplungsbereich des Antivalenz-Übertragungspfads koppelbare Signalsensoreinrichtung. Die Prüfschaltungsanordnung umfasst eine mit der Signalbildwechselschaltung und der Signalsensoreinrichtung verbundene Auswerteeinrichtung. Die Auswerteeinrichtung umfasst eine Signalbildwechselsteuerung. Die Signalbildwechselsteuerung ist eingerichtet zum Ansteuern der Signalbildwechselschaltung mit mindestens einem Schaltbefehl während einer Prüfphase. Die Auswerteeinrichtung umfasst ein Prüfmodul. Das Prüfmodul ist eingerichtet zum Prüfen der Funktionsfähigkeit des Systems während der Prüfphase, basierend auf dem mindestens einen Schaltbefehl und mindestens einem durch die Signalsensoreinrichtung erfassten Signalbild.

Indem im Gegensatz zum Stand der Technik anmeldungsgemäß eine Prüfschaltungsanordnung bereitgestellt wird, die mit einem zu prüfenden System koppelbar ist und zum Prüfen der Funktionalität des Systems eingerichtet ist, werden die Nachteiles des Stands der Technik zumindest reduziert und insbesondere die Fehlerdetektionszeit verkürzt. So wird durch die anmeldungsgemäße Prüfschaltungsanordnung eine Fehleroffenbarungszeit signifikant verkürzt. Ein detektierter Fehler kann daher zeitnah behoben werden. Weitere Störungen im System können zumindest reduziert werden.

Das zu prüfende (bzw. zu überwachende) System umfasst eine erste Vorrichtung und eine zweite Vorrichtung. Das System ist insbesondere ein System mit einem hohen Sicherheitsstandard. Bei einer bevorzugten Ausführungsform ist das System ein Schienensystem. In diesem Fall kann die erste Vorrichtung ein erstes Stellwerk sein und die zweite Vorrichtung ein zweites Stellwerk. Ein Stellwerk dient insbesondere in bekannter Weise zum Stellen mindestens einer Weiche des Schienensystems. Hierbei kann ein Betriebszustand des ersten Stellwerks an das zweite Stellwerk übertragen werden. Basierend auf dem empfangenen Betriebszustand bzw. des entsprechenden Signalbilds kann das zweite Stellwerk eine Stellung einer Weiche bewirken.

Insbesondere zur Erhöhung der Sicherheit erfolgt die Übertragung eines Signalwerts von der ersten Vorrichtung zu der zweiten Vorrichtung bei einem solchen System in Form eines antivalenten Signalbilds. Das Signalbild wird mittels einem zwischen der ersten Vorrichtung des Systems und der zweiten Vorrichtung des Systems angeordneten Antivalenz-Übertragungspfad übertragen. Der Antivalenz-Übertragungspfad des Systems umfasst (genau) einen ersten Übertragungsweg und einen zweiten (parallel zum ersten Übertragungsweg verlaufenden) Übertragungsweg. Ein Übertragungsweg kann insbesondere durch eine elektrisch leitfähige Verbindung bzw. einen Signalleiter gebildet sein.

Der Antivalenz-Übertragungspfad ist also eingerichtet zum Übertragen eines antivalenten Signalbilds von der ersten Vorrichtung zu der zweiten Vorrichtung. Wie bereits beschrieben wurde, wird ein übertragenes Signalbild durch die zweite Vorrichtung insbesondere nur dann als gültiges Signalbild erkannt, wenn sich der Signalwert des ersten Übertragungswegs von dem Signalwert des zweiten Übertragungswegs unterscheidet. Mit anderen Worten, gültige Signalzustände sind dabei nur solche, bei denen genau einer der genau zwei Übertragungswege den Signalwert überträgt.

Wenn beispielsweise ein Signalwert einen logischen Wert 1 hat, dann können über den ersten Übertragungsweg ein erstes Teilsignal mit dem logischen Wert 1 und über den zweiten Übertragungsweg ein zweites Teilsignal mit dem logischen Wert 0 übertragen werden. Das erste und das zweite Teilsignal bilden also das antivalente Signalbild, vorliegend (1,0). Wenn der Signalwert in einen logischen Wert 0 wechselt, dann können über den ersten Übertragungsweg ein erstes Teilsignal mit dem logischen Wert 0 und über den zweiten Übertragungsweg ein zweites Teilsignal mit dem logischen Wert 1 übertragen werden. Es wird also vorliegend das antivalente Signalbild (0,1) übertragen. Es versteht sich hierbei, dass die logischen Werte in der physikalischen Signalübertragung durch physikalisch messbare Größen repräsentiert werden. Beispielweise kann ein Signalwert durch einen Spannungswert (z.B. eine Kleinspannung) gegenüber einem gemeinsamen Bezugspotential repräsentiert sein, insbesondere ein Massepotenzial. Dass das erste Teilsignal einen logischen Wert 1 hat, kann beispielhaft bedeuten, dass auf einem Übertragungsweg in Form eines Niederspannungs-Signaldrahts eine Signalspannung von bespielweise 5 Volt anliegt. Ein logischer Wert 0 kann beispielhaft repräsentiert werden von einer Signalspannung von zum Beispiel weniger als 0,5 Volt.

Anmeldungsgemäß umfasst die Prüfschaltungsanordnung eine Signalbildwechselschaltung. Die Signalbildwechselschaltung ist in dem Antivalenz-Übertragungspfad anordenbar. Dies meint, dass die Signalbildwechselschaltung zwischen der ersten Vorrichtung und der zweiten Vorrichtung zwischengeschaltet werden kann, derart, dass insbesondere ein durch die erste Vorrichtung ausgesendetes Signalbild über die beiden Übertragungswege und der (zwischengeschalteten) Signalbildwechselschaltung an die zweite Vorrichtung übertragen wird.

Die Signalbildwechselschaltung ist ansteuerbar ausgebildet und insbesondere eingerichtet zum Ändern, insbesondere Wechseln, des durch die erste Vorrichtung ausgesendeten Signalbilds, basierend auf einem erhaltenen Schaltbefehl.

Darüber hinaus umfasst die Prüfschaltungsanordnung eine Signalsensoreinrichtung. Die Signalsensoreinrichtung ist eingerichtet zum Erfassen bzw. Detektieren eines an die zweite Vorrichtung übertragenen bzw. von dieser empfangenen Signalbilds. Das übertrage Signalbild ist insbesondere ein an dem ersten Übertragungsweg und dem zweiten Übertragungsweg zwischen der Signalbildwechselschaltung und einer Verarbeitungseinrichtung der zweiten Vorrichtung anliegendes Signalbild. Zum Erfassen des genannten Signalbilds ist die Signalsensoreinrichtung in einem Kopplungsbereich mit dem Antivalenz-Übertragungspfad (elektrisch) koppelbar, insbesondere mit dem ersten Übertragungsweg und dem zweiten Übertragungsweg.

Anmeldungsgemäß umfasst die Prüfschaltungsanordnung ferner eine Auswerteeinrichtung, die zumindest mit der Signalbildwechselschaltung und der Signalsensoreinrichtung verbunden ist. Die Auswerteeinrichtung ist eingerichtet zum Prüfen der Funktionsfähigkeit des Systems. Ein Prüfen der Funktionsfähigkeit des Systems meint insbesondere ein Feststellen, dass Signalbilder von der ersten Vorrichtung an die zweite Vorrichtung unverfälscht bzw. fehlerfrei übertragen werden. Mit anderen Worten, es kann überprüft werden, ob ein Übertragungsfehler bei der Übertragung von Signalbildern vorliegt oder nicht.

Die Auswerteinrichtung umfasst zumindest eine Signalbildwechselsteuerung und ein Prüfmodul. Die Signalbildwechselsteuerung ist eingerichtet zum Ansteuern der Signalbildwechselschaltung während einer Prüfphase mit mindestens einem Schaltbefehl. Ein Schaltbefehl bewirkt bei der anmeldungsgemäßen Signalbildwechselschaltung insbesondere, dass das ausgesendete Signalbild in bestimmter Weise durch die Signalbildwechselschaltung an die zweite Vorrichtung weitergeleitet wird, beispielsweise unverändert bleibt oder in bestimmter Weise verändert wird.

Die Prüfphase meint insbesondere die Zeitdauer, in der die Prüfung der Funktionsfähigkeit des Systems stattfindet. Dies ist zumindest die Zeitdauer, in der die Signalbildwechselschaltung eine Änderung des durch die erste Vorrichtung ausgesendeten Signalbilds bewirkt.

Das Prüfmodul ist eingerichtet zum Prüfen bzw. Feststellen der (fehlerfreien oder fehlerbehafteten) Funktionsweise, basierend auf dem erfassten Signalbild und dem Schaltbefehl, mit dem die Signalbildwechselschaltung angesteuert wird. Beispielsweise kann durch das Prüfmodul geprüft werden, ob das erfasste Signalbild dem Signalbild entspricht, das bei dem Schaltbefehl, mit dem die Signalbildwechselschaltung angesteuert wird, erwartet wird. Insbesondere kann ein entsprechender Vergleich durch das Prüfmodul durchgeführt werden. Das Prüfmodul kann insbesondere durch das Prüfen als Prüfergebnis bestimmen, ob eine fehlerfreie Funktionsfähigkeit bzw. Funktionsweise (z.B. dann, wenn das erfasste Signalbild dem erwarteten Signalbild entspricht) oder eine fehlerbehafte Funktionsfähigkeit bzw. Funktionsweise vorliegt (z.B. dann, wenn das erfasste Signalbild nicht dem erwarteten Signalbild entspricht).

Bei einer Ausführungsform der anmeldungsgemäßen Prüfschaltungsanordnung kann die Prüfschaltungsanordnung, insbesondere die Auswerteeinrichtung, mindestens ein Ausgabemodul umfassen. Das Ausgabemodul kann eingerichtet sein zum Ausgeben des Prüfergebnisses (z.B. fehlerfreie Funktionsfähigkeit oder fehlerhafte Funktionsfähigkeit) der durch das Prüfmodul durchgeführten Prüfung. Beispielsweise kann das Ausgabemodul ein Sender sein, eingerichtet zum Aussenden einer Nachricht, enthaltend das Prüfergebnis, über ein drahtloses und/oder drahtgebundenes Kommunikationsnetz an einen Empfänger, wie ein Nutzerendgerät des Systems. Alternativ oder zusätzlich kann das Ausgabemodul eine Anzeige sein, eingerichtet zum (optischen) Anzeigen des Prüfergebnisses. In einem einfachen Fall kann beispielsweise das Prüfergebnis durch unterschiedliche Farben auf der Anzeige dargestellt werden (z.B. rot leuchtende Anzeige (z.B. LED) für eine fehlerhafte Funktionsfähigkeit und eine grün leuchtende Anzeige für eine fehlerfreie Funktionsfähigkeit). Bei anderen Varianten der Anmeldung kann alternativ oder zusätzlich auf einer Anzeige ein entsprechender Text angezeigt werden und/oder die Anzeige eine akustische Anzeige sein, eingerichtet zum Abgeben eines akustischen Signals (z.B. nur bei einer fehlerhaften Funktionsfähigkeit).

Gemäß einer bevorzugten Ausführungsform der anmeldungsgemäßen Prüfschaltungsanordnung kann die Signalbildwechselschaltung eine Schaltbrücke sein. Eine Schaltbrücke ermöglicht in besonders einfacher Weise ein durch die erste Vorrichtung versendetes Signalbild in bestimmter Weise zu verändern oder unverändert zu belassen. Eine Schaltbrücke bzw. eine Brückenschaltung kann aus Widerständen gebildet sein und beispielweise als Parallelschaltung zweier Spannungsteiler interpretieren werden, zwischen deren Ausgangsklemmen ein Brückenzweig liegen kann. Insbesondere kann bei einer Schaltbrücke die Spannung und/oder der Strom im Brückenzweig je nach Einstellung der Widerstände bzw. abhängig von dem Schaltbefehl verändert werden.

Gemäß einer weiteren bevorzugten Ausführungsform der anmeldungsgemäßen Prüfschaltungsanordnung kann die Signalbildwechselsteuerung eingerichtet sein zum Ansteuern der Signalbildwechselschaltung, derart, dass eine durch die erste Vorrichtung bewirkte Signalbildänderung von einem ersten Signalbild zu einem zweiten Signalbild simuliert wird, insbesondere obwohl der tatsächlich Zustand der ersten Vorrichtung bzw. das tatsächlich durch die erste Vorrichtung ausgesendete Signalbild unverändert bleibt. Dies ermöglicht eine zuverlässige Prüfung sowie eine besonders zeitnahe Detektion eines Fehlers, auch wenn sich ein Betriebszustand der ersten Vorrichtung über eine längere Zeitdauer (z.B. zwischen 1 Monat bis hin zu mehr als 1 Jahr) nicht ändert.

Darüber hinaus kann gemäß einer weiteren Ausführungsform der anmeldungsgemäßen Prüfschaltungsanordnung die Signalbildwechselsteuerung eingerichtet sein zum Ansteuern der Signalbildwechselschaltung mit dem mindestens einen Schaltbefehl, basierend auf einem vorgegebenen Prüfschema. Das Prüfschema kann vorzugsweise einen während der Prüfphase anzuwendenden Prüfalgorithmus angeben. Beispielweise kann das Prüfschema vorgeben, das während der Prüfphase zumindest zwei unterschiedliche Schaltzustände bei der Signalbildwechselschaltung eingestellt werden, um insbesondere mindestens einen Signalbildwechsel zu bewirken. Beispielsweise kann das Prüfschema vorgeben, dass in einem ersten Prüfschritt ein erster Schaltbefehl angewendet (und ein erstes resultierendes Signalbild erfasst) wird und in einem zweiten Prüfschritt ein zweiter Schaltbefehl angewendet (und ein zweites resultierendes Signalbild erfasst) wird. In einen Fall kann der erste Schaltbefehl erste Instruktionen enthalten, um den ersten Schaltzustand einzustellen. Der zweite Schaltbefehl kann insbesondere zweite sich von den ersten Instruktionen unterscheidende Instruktionen enthalten, um den zweiten Schaltzustand einzustellen. Alternativ können der erste und der zweite Schaltbefehl identische Schaltbefehle sein, wobei ein solcher Schaltbefehl bei einem Empfang durch die Signalbildwechselschaltung (stets) einen Signalbildwechsel bewirkt, wie noch näher beschrieben wird. Durch Anwenden eines bestimmten Prüfschema kann eine umfassende Prüfung der Funktionsweise des Systems erfolgen.

Das Prüfschema kann zusätzlich vorgeben, dass nach einer Durchführung der Prüfung, insbesondere nur nach einem Feststellen einer fehlerfreien Funktionsfähigkeit, die Signalbildwechselschaltung mit einem Schaltbefehl angesteuert wird, derart, dass die Signalbildwechselschaltung in den Schaltzustand versetzt wird, in dem ein Signalbild nicht durch die Signalbildwechselschaltung verändert wird.

Gemäß einer bevorzugten Ausführungsform der anmeldungsgemäßen Prüfschaltungsanordnung kann die Signalbildwechselschaltung eingerichtet sein zum Umschalten zwischen zumindest einem ersten Schaltzustand und einem zweiten Schaltzustand, basierend auf dem mindestens einen Schaltbefehl. In dem ersten Schaltzustand kann das durch die erste Vorrichtung ausgesendete Signalbild durch die Signalbildwechselschaltung unverändert bleiben. In dem zweiten Schaltzustand kann das durch die erste Vorrichtung ausgesendete Signalbild durch die Signalbildwechselschaltung invertiert werden (z.B. Signalbild (1,0) wird zu (0,1) oder umgekehrt).

Mit anderen Worten, die Signalbildwechselschaltung (insbesondere eine Schaltbrücke) kann eingerichtet sein, zwischen wenigstens einem ersten Schaltzustand und einem zweiten Schaltzustand umzuschalten. In dem ersten Schaltzustand kann ein erstes Teilsignal des Signalbilds, das über den ersten Übertragungsweg übertragen wird und insbesondere als erstes Eingangssignal an einem ersten Eingang der Signalbildwechselschaltung empfangen wird, über einen ersten Ausgang der Signalbildwechselschaltung als erstes Ausgangssignal über den ersten Übertragungsweg an die zweite Vorrichtung weitergeleitet werden. In dem ersten Schaltzustand kann ein zweites Teilsignal des Signalbilds, das über den zweiten Übertragungsweg übertragen wird und insbesondere als zweites Eingangssignal an einem zweiten Eingang der Signalbildwechselschaltung empfangen wird, über einen zweiten Ausgang der Signalbildwechselschaltung als zweites Ausgangssignal über den zweiten Übertragungsweg an die zweite Vorrichtung weitergeleitet werden.

In dem zweiten Schaltzustand kann das erste Teilsignal des Signalbilds, das über den ersten Übertragungsweg übertragen wird und insbesondere als erstes Eingangssignal an einem ersten Eingang der Signalbildwechselschaltung empfangen wird, über den zweiten Ausgang der Signalbildwechselschaltung als erstes Ausgangssignal über den zweiten Übertragungsweg an die zweite Vorrichtung weitergeleitet werden. In dem zweiten Schaltzustand kann das zweite Teilsignal des Signalbilds, das über den zweiten Übertragungsweg übertragen wird und insbesondere als zweites Eingangssignal an einem zweiten Eingang der Signalbildwechselschaltung empfangen wird, über den ersten Ausgang der Signalbildwechselschaltung als zweites Ausgangssignal über den ersten Übertragungsweg an die zweite Vorrichtung weitergeleitet werden. Beispielsweise wird das durch die erste Vorrichtung ausgesendete Signalbild (1,0) als Signalbild (0,1) durch die zweite Vorrichtung empfangen.

Gemäß einer weiteren Ausführungsform der anmeldungsgemäßen Prüfschaltungsanordnung kann die Signalbildwechselschaltung in einem ersten zwischen einem Signalausgang der ersten Vorrichtung und einem Signaleingang der zweiten Vorrichtung verlaufenden Antivalenz-Übertragungspfadabschnitt anordenbar sein. Der Kopplungsbereich kann in einem zweiten zwischen dem Signaleingang der zweiten Vorrichtung und einer Verarbeitungseinrichtung der zweiten Vorrichtung verlaufenden Antivalenz-Übertragungspfadabschnitt angeordnet sein. Die Anordnung des Kopplungsbereich nach dem Signaleingang und insbesondere vor der Verarbeitungseinrichtung stellt insbesondere sicher, dass sämtliche Übertragungsfehler bis zum Erreichen der Verarbeitungseinrichtung durch die Prüfschaltungsanordnung detektierbar sind.

Eine Verarbeitungseinrichtung (beispielsweise umfassend einen Prozessor) der zweiten Vorrichtung kann insbesondere eingerichtet sein zum Durchführen bzw. Ausführen eines bestimmten Prozesses, basierend auf dem erhaltenen Signalbild bzw. basierend auf dem Betriebszustand der ersten Vorrichtung. Insbesondere kann sich der Betriebszustand der zweiten Vorrichtung ändern. Wie beschrieben wurde, kann beispielsweise bei einem Stellwerk die Verarbeitungseinrichtung des Stellwerks aufgrund eines geänderten Signalbilds eine Stellung einer Weiche oder dergleichen bewirken.

Gemäß einer weiteren Ausführungsform der anmeldungsgemäßen Prüfschaltungsanordnung kann die Signalsensoreinrichtung einen ersten mit dem ersten Übertragungsweg des Antivalenz-Übertragungspfads (in dem Kopplungsbereich) koppelbaren Signalsensor umfassen. Die Signalsensoreinrichtung kann einen zweiten mit dem zweiten Übertragungsweg des Antivalenz-Übertragungspfads (in dem Kopplungsbereich) koppelbaren Signalsensor umfassen. In sicherer Weise kann der Signalwert des ersten Übertragungswert und der Signalwert des zweiten Übertragungswerts erfasst werden, insbesondere gemessen werden. Mit anderen Worten, in sicherer Weise kann das durch die zweite Vorrichtung empfangene Signalbild erfasst werden.

Vorzugsweise kann der erste Signalsensor ein erster Optokoppler sein. Ferner kann vorzugsweise der zweite Signalsensor ein zweiter Optokoppler sein. Der erste Optokoppler kann eingerichtet sein zum Messen einer zwischen dem ersten Übertragungsweg und einem Bezugspotential vorliegenden ersten Spannung und der zweite Optokoppler kann eingerichtet sein zum Messen einer zwischen dem zweiten Übertragungsweg und dem Bezugspotential vorliegenden zweiten Spannung. Beispielsweise kann das Bezugspotential durch einen gemeinsamen Nullleiter gebildet sein. In besonders sicherer Weise kann das übertragene Signalbild erfasst werden.

Gemäß einer weiteren Ausführungsform der anmeldungsgemäßen Prüfschaltungsanordnung kann das Prüfmodul eingerichtet sein zum Prüfen der Funktionsfähigkeit des Systems (nur) während der Prüfphase, basierend auf dem mindestens einen Schaltbefehl, dem mindestens einen durch die Signalsensoreinrichtung erfassten Signalbild und einem vorgegebenen Prüfkriterium (das insbesondere von dem vorgegebenen Prüfschema abhängt). Insbesondere kann das Prüfkriterium vorgeben, welches Signalbild bei einem bestimmten Schaltzustand erwartet werden kann. Das Prüfschema kann beispielsweise vorgeben, welches Signalbild bei einer fehlerfreien Funktionsfähigkeit bei einem Anwenden eines bestimmten Schaltbefehls zu erwarten ist. Das Prüfmodul kann dann anhand des von der Signalbildwechselsteuerung angewendeten Schaltbefehls das zu erwartende Signalbild bestimmen. Dann kann das zu erwartende Signalbild durch das Prüfmodul mit dem von der Signalsensoreinrichtung erfassten Signalbild verglichen werden. Wenn die genannten Signalbilder identisch sind, kann eine fehlerfreie Funktionsfähigkeit angenommen werden. Bei Detektion einer Abweichung kann eine fehlerhafte Funktionsfähigkeit festgestellt werden. Es versteht sich, dass bei Varianten der Anmeldung das Prüfkriterium vorgeben, welches Signalbild bei einer fehlerhaften Funktionsfähigkeit bei einem Anwenden eines bestimmten Schaltbefehls zu erwarten ist. In noch zuverlässigerer Weise kann die Prüfung durchgeführt werden.

Darüber hinaus kann, gemäß einer weiteren Ausführungsform der anmeldungsgemäßen Prüfschaltungsanordnung, die Auswerteeinrichtung mindestens ein Schaltzustandsbestimmungsmodul umfassen. Das Schaltzustandsbestimmungsmodul kann eingerichtet sein zum Bestimmen des augenblicklichen Schaltzustands der Signalbildwechselschaltung, basierend auf einem von der Signalbildwechselschaltung empfangbaren und/oder auslesbaren Schaltzustandsdatum. Insbesondere ist das Schaltzustandsdatum ein Signal und/oder Signalwert. Das Schaltzustandsdatum kann ein erstes Signal (bzw. ein erster Signalwert) sein, wenn sich die Signalbildwechselschaltung in dem ersten Schaltzustand befindet. Das Schaltzustandsdatum kann ein zweites sich von dem ersten Signal unterscheidendes Signal (bzw. ein unterscheidender Signalwert) sein, wenn sich die Signalbildwechselschaltung in dem ersten Schaltzustand befindet. Hierdurch kann sichergestellt werden, dass die Signalbildwechselschaltung entsprechend einem Schaltbefehl tatsächlich schaltet bzw. einen bestimmten Schaltzustand einnimmt. Es kann also insbesondere sichergestellt werden, dass die Ursache einer festgestellten fehlerhaften Funktionsweise nicht die Signalbildwechselschaltung der Prüfschaltungsanordnung ist. Mit anderen Worten, wenn die Signalbildwechselschaltung die Ursache des Fehlers ist, kann dies festgestellt werden.

Gemäß einer weiteren bevorzugten Ausführungsform der anmeldungsgemäßen Prüfschaltungsanordnung kann die Prüfschaltungsanordnung (insbesondere die Auswerteeinrichtung) ein Prüfmoduseinstellmodul umfassen. Das Prüfmoduseinstellmodul kann eingerichtet sein zum Setzen der zweiten Vorrichtung (insbesondere der Verarbeitungseinrichtung der zweiten Vorrichtung) in einen Prüfmodus während der Prüfphase. Wie beschrieben wurde, kann während der Prüfphase ein Signalbildwechsel simuliert werden, der tatsächlich nicht durch die erste Vorrichtung ausgesendete wurde. Mit anderen Worten, der Zustand der ersten Vorrichtung hat sich in der Prüfphase nicht geändert. Um zu verhindern, dass die zweite Vorrichtung, insbesondere die Verarbeitungseinrichtung, während der Prüfphase von einem tatsächlichen Zustandswechsel aufgrund des empfangenen geänderten Signalbilds ausgeht, kann die zweite Vorrichtung in einen Prüfmodus gesetzt werden. In diesem Prüfmodus kann die zweite Vorrichtung, insbesondere die Verarbeitungseinrichtung der zweiten Vorrichtung, eingerichtet sein, einen Signalbildwechsel zu ignorieren. Mit anderen Worten, die Verarbeitungseinrichtung führt in dem Prüfmodus keine Aktion aus.

Grundsätzlich kann eine Prüfschaltungsanordnung für eine temporäre Kopplung mit dem zu prüfenden System eingerichtet sein. Beispielsweise kann eine Prüfschaltungsanordnung im Wesentlichen nur während der Prüfphase mit dem zu prüfenden System verbunden werden.

Gemäß einer weitere Ausführungsform kann die Prüfschaltungsanordnung dauerhaft mit dem zu prüfenden System verbunden und insbesondere in diesem System integriert sein. Die Prüfschaltungsanordnung kann den Prüfungsprozess beispielsweise in definierten und insbesondere regelmäßigen Zeitabständen (automatisch) durchführen. Dies kann beispielsweise durch das Prüfschema vorgegeben sein.

Alternativ oder zusätzlich kann die Prüfschaltungsanordnung ein Detektionsmodul umfassen, eingerichtet zum Detektieren eines Prüfstartbefehls. Beispielsweise kann die Prüfschaltungsanordnung einen manuell betätigbaren Schalter umfassen. Eine Betätigung des Schalters kann durch das Detektionsmodul detektiert und insbesondere als Prüfstartbefehl interpretiert werden. Alternativ oder zusätzlich kann die Prüfschaltungsanordnung einen Empfänger umfassen, eingerichtet zum Empfangen eines Prüfstartbefehls (z.B. ausgesendet durch ein Nutzerendgerät) über ein drahtloses und/oder drahtgebundenes Kommunikationsnetz. Wenn das Detektionsmodul eine Betätigung des Schalters detektiert und dies insbesondere als Prüfstartbefehl interpretiert und/oder das Detektionsmodul ein Empfangen eines Prüfstartbefehls mittels des Empfängers detektiert, kann die Prüfung des Systems initiiert werden.

Wie beschrieben wurde, kann in einem Prüfprozess zunächst zumindest die zweite Vorrichtung in einen Prüfmodus gesetzt werden. Dann kann die Prüfung und insbesondere die Auswertung durchgeführt werden, beispielsweise entsprechend einem vorgegebenen Prüfschema und insbesondere einem vorgegebenen Prüfkriterium. Nach einer Beendigung der Prüfung bzw. nach der Prüfphase kann die zweite Vorrichtung wieder in den (normalen) Betriebsmodus gesetzt werden. Insbesondere kann die Prüfphase damit enden, dass die zweite Vorrichtung wieder in den Betriebsmodus gesetzt wird/ist.

Bei einer Ausführungsform kann das Zurücksetzen in den (normalen) Betriebsmodus nur dann erfolgen, wenn durch das Prüfmodul eine fehlerfreie Funktionsfähigkeit festgestellt wird. Wenn eine fehlerbehaftete Funktionsfähigkeit festgestellt wird, kann zumindest die zweite Vorrichtung des Systems in einen Fehlermodus (bis zu einer Behebung des Fehlers) gesetzt werden. Wie bereits beschrieben wurde, kann zusätzlich eine Ausgabe des Prüfergebnisses erfolgen.

Ein weiterer Aspekt der Anmeldung ist ein (insbesondere zuvor beschriebenes und insbesondere zu prüfendes) System. Das System umfasst eine erste Vorrichtung. Das System umfasst eine zweite Vorrichtung. Das System umfasst einen zwischen der ersten Vorrichtung und der zweiten Vorrichtung angeordneten Antivalenz-Übertragungspfad mit einem ersten Übertragungsweg und einem zweiten Übertragungsweg. Der Antivalenz-Übertragungspfad ist eingerichtet zum Übertragen eines antivalenten Signalbilds von der ersten Vorrichtung zu der zweiten Vorrichtung. Das System umfasst mindestens eine zuvor beschriebene Prüfschaltungsanordnung.

Gemäß einer Ausführungsform des anmeldungsgemäßen Systems kann die erste Vorrichtung eine erste Antivalenzschaltung umfassen. Die erste Antivalenzschaltung kann eingerichtet sein zum Generieren eines antivalenten Signalbilds aus einem zu übertragenen Signalwert, basierend auf einem vorgegebenen Codierschema. Das Codierschema kann z.B. bei einem zu übertragenen logischen Wert 1 das Signalbild (1,0) und bei einem zu übertragenen logischen Wert 0 das Signalbild (0,1) vorgeben. Entsprechend kann dann die Antivalenzschaltung die zu übertragenen Signalbilder generieren und insbesondere aussenden.

Gemäß einer weiteren Ausführungsform des anmeldungsgemäßen Systems kann die zweite Vorrichtung (insbesondere die Verarbeitungseinrichtung der zweiten Vorrichtung) eine zweite Antivalenzschaltung umfassen. Die zweite Antivalenzschaltung kann eingerichtet sein zum Detektieren des übertragenen Signalwerts aus dem empfangenen antivalenten Signalbilds, basierend auf einem vorgegebenen und zu dem Codierschema korrespondierenden Decodierschema. Das Decodierschema kann beispielsweise vorgeben, dass bei einem empfangenen Signalbild (1,0) der übertragene Signalwert der logische Wert 1 und bei einem empfangenen Signalbild (0,1) der übertragene Signalwert der logische Wert 0 ist.

Gemäß einer bevorzugten Ausführungsform des anmeldungsgemäßen Systems kann die erste Vorrichtung ein erstes Stellwerk sein und die zweite Vorrichtung ein zweites Stellwerk sein. Das System kann insbesondere ein Schienensystem sein. Die Sicherheit in einem Schienensystem kann weiter verbessert werden.

Ein weiterer Aspekt der Anmeldung ist ein Verfahren zum Prüfen der Funktionsfähigkeit eines Systems, insbesondere eines zuvor beschriebenen Systems. Das System umfasst einen zwischen einer ersten Vorrichtung des Systems und einer zweiten Vorrichtung des Systems angeordneten Antivalenz-Übertragungspfad mit einem ersten Übertragungsweg und einem zweiten Übertragungsweg. Der Antivalenz-Übertragungspfad kann eingerichtet sein zum Übertragen eines antivalenten Signalbilds von der ersten Vorrichtung zu der zweiten Vorrichtung. Das Verfahren umfasst:
- Ansteuern (beispielweise durch eine vorbeschriebene Signalbildwechselsteuerung) einer in dem Antivalenz-Übertragungspfad angeordneten Signalbildwechselschaltung mit mindestens einem Schaltbefehl,
- Erfassen, durch eine mit einem in Übertragungsrichtung hinter der Signalbildwechselschaltung angeordneten Kopplungsbereich des Antivalenz-Übertragungspfads gekoppelte (insbesondere vorbeschriebene) Signalsensoreinrichtung, eines Signalbilds, und
- Prüfen (beispielweise durch ein vorbeschriebenes Prüfmodul) der Funktionsfähigkeit des Systems während einer Prüfphase, zumindest basierend auf dem mindestens einen Schaltbefehl und dem mindestens einen durch die Signalsensoreinrichtung erfassten Signalbild.

Ein noch weiterer Aspekt der Anmeldung ist eine Verwendung einer zuvor beschriebenen Prüfschaltungsanordnung zum Prüfen der Funktionsfähigkeit eines Systems mit einem zwischen einer ersten Vorrichtung des Systems und einer zweiten Vorrichtung des Systems angeordneten Antivalenz-Übertragungspfad mit einem ersten Übertragungsweg und einem zweiten Übertragungsweg, wobei der Antivalenz-Übertragungspfad eingerichtet ist zum Übertragen eines antivalenten Signalbilds von der ersten Vorrichtung zu der zweiten Vorrichtung. Die erste Vorrichtung kann insbesondere ein erstes Stellwerk sein und die zweite Vorrichtung ein zweites Stellwerk. Das System kann insbesondere ein Schienensystem sein. Die Sicherheit in einem Schienensystem kann weiter verbessert werden.

Ein/e zuvor beschriebene/s Modul, Element, Vorrichtung etc. kann zumindest teilweise Hardwareelemente (z.B. Prozessor, Speichermittel etc.) und/oder zumindest teilweise Softwareelemente (z.B. ausführbaren Code) umfassen. Beispielsweise kann die Auswerteeinrichtung als Hardwareelemente eine Komparatorschaltung mit mindestens einem Komparator umfassen, eingerichtet zum Durchführen der genannten Prüfung, insbesondere zum Vergleichen von Signalwerten bzw. Spannungswerten.

Alternativ kann insbesondere die Auswerteeinrichtung in einer Datenverarbeitungsvorrichtung implementiert bzw. durch die Datenverarbeitungsvorrichtung gebildet sein und insbesondere eine Mehrzahl von durch einen Prozessor der Datenverarbeitungsvorrichtung ausführbaren (Software-) Modulen (z.B. Prüfmodul, Signalbildwechselschaltung etc.) aufweisen.

Ein weiterer Aspekt der Anmeldung ist ein Computerprogramm, umfassend Programmanweisungen, die einen Prozessor zur Ausführung und/oder Steuerung des zuvor beschriebenen Verfahrens veranlassen, wenn das Computerprogramm von dem Prozessor ausgeführt wird.

Ein noch weiterer Aspekt ist eine Datenverarbeitungsvorrichtung, eingerichtet zur Ausführung und/oder Steuerung des zuvor beschriebenen Verfahrens oder umfassend jeweilige Mittel zur Ausführung und/oder Steuerung der Schritte des zuvor beschriebenen Verfahrens.

Die Mittel der offenbarten Datenverarbeitungsvorrichtung können Hardware- und/oder Software-Komponenten umfassen. Die Mittel können beispielsweise mindestens einen Speicher mit Programmanweisungen eines Computerprogramms (z.B. des erfindungsgemäßen Computerprogramms) und mindestens einen Prozessor ausgebildet zum Ausführen von Programmanweisungen aus dem mindestens einen Speicher umfassen. Dementsprechend soll gemäß der Anmeldung auch zumindest eine Datenverarbeitungsvorrichtung als offenbart verstanden werden, die zumindest einen Prozessor und zumindest einen Speicher mit Programmanweisungen umfasst, wobei der zumindest eine Speicher und die Programmanweisungen eingerichtet sind, gemeinsam mit dem zumindest einen Prozessor, die Datenverarbeitungsvorrichtung zu veranlassen, das Verfahren gemäß der Anmeldung auszuführen und/oder zu steuern.

Die anmeldungsgemäße Datenverarbeitungsvorrichtung ist insbesondere ein Teil der Prüfschaltungsanordnung.

Es sei ferner angemerkt, dass Begriffe, wie "erste"; "zweite", "weitere" etc. nicht eine Reihenfolge angeben, sondern insbesondere zur Unterscheidung zweier Elemente (z.B. Übertragungsweg, Antivalenz-Übertragungspfadabschnitt etc.) dienen.

Die Merkmale der Prüfschaltungsanordnungen, der Systeme, Verfahren und Verwendungen sind frei miteinander kombinierbar. Insbesondere können Merkmale der Beschreibung und/oder der abhängigen Ansprüche, auch unter vollständiger oder teilweiser Umgehung von Merkmalen der unabhängigen Ansprüche, in Alleinstellung oder frei miteinander kombiniert eigenständig erfinderisch sein.

Es gibt nun eine Vielzahl von Möglichkeiten, die anmeldungsgemäße Prüfschaltungsanordnung, das anmeldungsgemäße System, das anmeldungsgemäße Verfahren und die anmeldungsgemäße Verwendung auszugestalten und weiterzuentwickeln. Hierzu sei einerseits verwiesen auf die den unabhängigen Patentansprüchen nachgeordneten Patentansprüche, andererseits auf die Beschreibung von Ausführungsbeispielen in Verbindung mit der Zeichnung. In der Zeichnung zeigt:
- Fig. 1: eine schematische Ansicht eines Ausführungsbeispiels einer Prüfschaltungsanordnung gemäß der vorliegenden Anmeldung,
- Fig. 2: eine schematische Ansicht eines Ausführungsbeispiels eines Systems gemäß der vorliegenden Anmeldung mit einem Ausführungsbeispiel einer Prüfschaltungsanordnung gemäß der vorliegenden Anmeldung,
- Fig. 3a: eine schematische Ansicht eines Ausführungsbeispiels eines Systems gemäß der vorliegenden Anmeldung mit einer Signalbildwechselschaltung in einem ersten Schaltzustand,

- Fig. 3b: eine schematische Ansicht des Systems nach Figur 3a mit der Signalbildwechselschaltung in einem zweiten Schaltzustand,
- Fig. 4a: eine schematische Ansicht eines Ausführungsbeispiels eines Systems gemäß der vorliegenden Anmeldung mit einer Signalbildwechselschaltung in einem ersten Schaltzustand,
- Fig. 4b: eine schematische Ansicht des Systems nach Figur 4a mit der Signalbildwechselschaltung in einem zweiten Schaltzustand,
- Fig. 5a: eine schematische Ansicht eines Ausführungsbeispiels eines Systems gemäß der vorliegenden Anmeldung mit einer Signalbildwechselschaltung in einem ersten Schaltzustand,
- Fig. 5b: eine schematische Ansicht des Systems nach Figur 5a mit der Signalbildwechselschaltung in einem zweiten Schaltzustand, und
- Fig. 6: ein Diagramm eines Ausführungsbeispiels eines Verfahrens gemäß der vorliegenden Anmeldung.

Nachfolgend werden für ähnliche Elemente ähnliche Bezugszeichen verwendet.

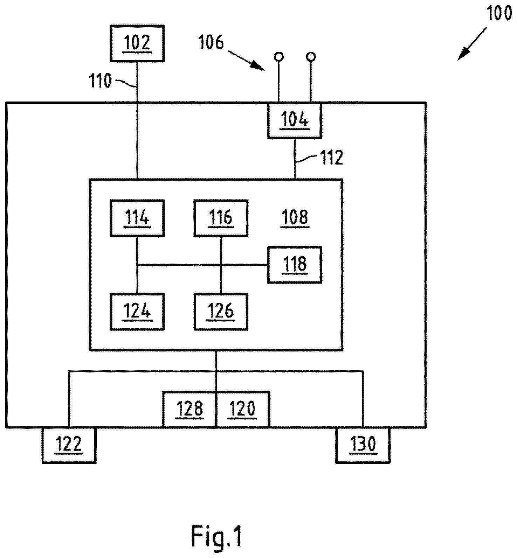

Die Figur 1 zeigt eine schematische Ansicht eines Ausführungsbeispiels einer Prüfschaltungsanordnung 100 gemäß der vorliegenden Anmeldung für ein (nicht gezeigtes) System, insbesondere zum Prüfen der Funktionsfähigkeit des Systems. Das System umfasst einen zwischen einer ersten Vorrichtung des Systems und einer zweiten Vorrichtung des Systems angeordneten Antivalenz-Übertragungspfad mit einem ersten Übertragungsweg und einem zweiten Übertragungsweg, wobei der Antivalenz-Übertragungspfad eingerichtet ist zum Übertragen eines antivalenten Signalbilds von der ersten Vorrichtung zu der zweiten Vorrichtung.

Die Prüfschaltungsanordnung 100 umfasst eine in dem Antivalenz-Übertragungspfad anordenbare Signalbildwechselschaltung 102. Die Signalbildwechselschaltung 102 ist insbesondere eine Schaltbrücke. Die Signalbildwechselschaltung 102 ist ansteuerbar und kann insbesondere zwischen einem ersten Schaltzustand und einem zweiten Schaltzustand umgeschaltet werden, der sich von dem ersten Schaltzustand unterscheidet. Vorzugsweise kann in dem ersten Schaltzustand das durch die erste Vorrichtung ausgesendete Signalbild durch die Signalbildwechselschaltung 102 unverändert bleiben. In dem zweiten Schaltzustand kann das durch die erste Vorrichtung ausgesendete Signalbild durch die Signalbildwechselschaltung invertiert werden.

Ferner umfasst die Prüfschaltungsanordnung 100 eine mit einem in Übertragungsrichtung des Antivalenz-Übertragungspfads hinter der Signalbildwechselschaltung 102 angeordneten Kopplungsbereich des Antivalenz-Übertragungspfads koppelbare Signalsensoreinrichtung 104. Zum Koppeln kann insbesondere eine Koppelverbindung 106 (beispielsweise gebildet durch zwei elektrische Leiter jeweils mit einem Anschluss) vorgesehen sein.

Neben der Signalbildwechselschaltung 102 und der Signalsensoreinrichtung 104 umfasst die Prüfschaltungsanordnung 100 eine mit der Signalbildwechselschaltung 102 (insbesondere über eine erste Verbindung 110) und der Signalsensoreinrichtung 104 (insbesondere über eine weitere Verbindung 112) verbundene Auswerteeinrichtung 108. Wie bereits beschrieben wurde, kann die Auswerteeinrichtung 108 durch Hardwareelemente und/oder durch eine Datenverarbeitungsvorrichtung gebildet sein.

Die Auswerteeinrichtung 108 umfasst zumindest eine Signalbildwechselsteuerung 114 und ein Prüfmodul 116. Die Signalbildwechselsteuerung 114 ist eingerichtet zum Ansteuern der Signalbildwechselschaltung 102 (insbesondere über die erste Verbindung 110) mit mindestens einem Schaltbefehl während einer Prüfphase. Der mindestens eine Schaltbefehl dient insbesondere zum Bewirken eines Umschaltens des Schaltzustands von dem augenblicklich eingestellten Schaltzustand (beispielsweise der erste Schaltzustand) in den anderen Schaltzustand (beispielsweise der zweite Schaltzustand) oder zum Einstellen eines bestimmten Schaltzustands, also z.B. des ersten Schaltzustands oder des zweiten Schaltzustands (unabhängig von dem augenblicklich eingestellten Schaltzustand).

Vorzugsweise kann ein Prüfschema vorgegebenen sein, das beispielsweise in einem optionalen Datenspeicher 118 der Prüfschaltungsanordnung 100 gespeichert ist. Das Prüfschema kann beispielsweise den mindestens einen Schaltbefehl definieren, mit dem die Signalbildwechselsteuerung 114 die Schaltbildwechselschaltung 102 während der Prüfphase ansteuern soll.

Das Prüfmodul 116 ist eingerichtet zum Prüfen der Funktionsfähigkeit des Systems während der Prüfphase, basierend auf dem mindestens einen durch die Signalbildwechselsteuerung 114 angewendeten Schaltbefehl und dem mindestens einen durch die Signalsensoreinrichtung 104 erfassten Signalbild. Beispielsweise kann das Prüfmodul 116 prüfen, insbesondere vergleichen, ob das erfasste Signalbild dem Signalbild entspricht, das bei dem Schaltbefehl, mit dem die Signalbildwechselschaltung 102 angesteuert wird, erwartet wird. Vorzugsweise kann in dem Datenspeicher 118 ein vorgegebenes Prüfkriterium gespeichert sein, das insbesondere auf das Prüfschema abgestimmt sein kann. Insbesondere kann das Prüfkriterium das mindestens eine Signalbild definieren, das bei Anwendung des Prüfschemas durch die Signalbildwechselsteuerung 114 zu erwarten ist, wenn die Funktionsfähigkeit des Systems fehlerfrei ist (oder fehlerhaft).

Optional kann die Prüfschaltungsanordnung 100 weitere Module/Elemente umfassen. Beispielsweise kann die Prüfschaltungsanordnung 100 ein erstes Ausgabemodul 120 in Form eines Senders und/oder ein zweites Ausgabemodul 122 in Form einer Anzeige umfassen. Ein Ausgabemodul 120, 122 kann insbesondere eingerichtet sein zum Ausgeben des Prüfergebnisses (z.B. Funktionsfähigkeit des Systems ist fehlerfrei oder fehlerhaft). Beispielsweise kann der Sender eine entsprechende Nachricht an ein (nicht gezeigtes) Nutzerendgerät des Systems übertragen. Alternativ oder zusätzlich kann die optische Anzeige das Prüfergebnis anzeigen, beispielsweise als Text, Symbol und/oder Farbton. Insbesondere bei einer fehlerhaften Funktionsfähigkeit können dann zeitnah entsprechende Maßnahmen zur Behebung des Fehlers ergriffen werden.

Ferner kann die Prüfschaltungsanordnung 100 optional ein Detektionsmodul 124, ein Prüfmoduseinstellmodul 126, einen Empfänger 128 und/oder einen manuell betätigbaren Schalter 130 umfassen. Beispielsweise kann durch eine Betätigung des Schalters 130 und/oder durch Senden eines Prüfstartbefehls (beispielsweise durch ein Nutzerendgerät des Systems) an den Empfänger 128 eine Durchführung der Prüfung der Funktionalität des Systems initiiert werden. Bei Varianten der Anmeldung kann die Prüfung auch automatisch initiiert werden, beispielsweise immer nach Ablauf einer bestimmten Zeitdauer (ohne dass es in dieser Zeitdauer zu einem Signalbildwechsel gekommen ist). Das Detektionsmodul 124 kann insbesondere eingerichtet sein zum Detektieren einer Betätigung des Schalters 130 und/oder eines Empfangs des Prüfstartbefehls.

Wenn das Detektionsmodul 124 eine Betätigung des Schalters 130 detektiert und dies insbesondere als Prüfstartbefehl interpretiert und/oder das Detektionsmodul 124 ein Empfangen eines Prüfstartbefehls mittels des Empfängers 128 detektiert, kann die Prüfung der Funktionsfähigkeit des Systems gestartet werden. Zunächst kann durch das Prüfmoduseinstellmodul 126 zumindest die zweite Vorrichtung in einen Prüfmodus gesetzt werden. Dann kann die Prüfung und insbesondere die Auswertung durchgeführt werden, beispielsweise entsprechend einem vorgegebenen Prüfschema und insbesondere einem vorgegebenen Prüfkriterium. Nach einer Beendigung der Prüfung bzw. nach der Prüfphase kann die zweite Vorrichtung wieder in den (normalen) Betriebsmodus gesetzt werden. Das Setzen der zweiten Vorrichtung in den (normalen) Betriebsmodus kann die Prüfphase beenden. Insbesondere die Signalbildwechselsteuerung 102 kann zudem wieder in den ersten Schaltzustand, bei dem das durch die erste Vorrichtung ausgesendete Signalbild unverändert bleibt, gesetzt werden.

Vorzugsweise kann das Zurücksetzen in den (normalen) Betriebsmodus nur dann erfolgen, wenn durch das Prüfmodul 116 eine fehlerfreie Funktionsfähigkeit festgestellt wird. Wenn eine fehlerbehaftete Funktionsfähigkeit festgestellt wird, kann zumindest die zweite Vorrichtung in einen Fehlermodus (bis zu einer Behebung des Fehlers) gesetzt werden.

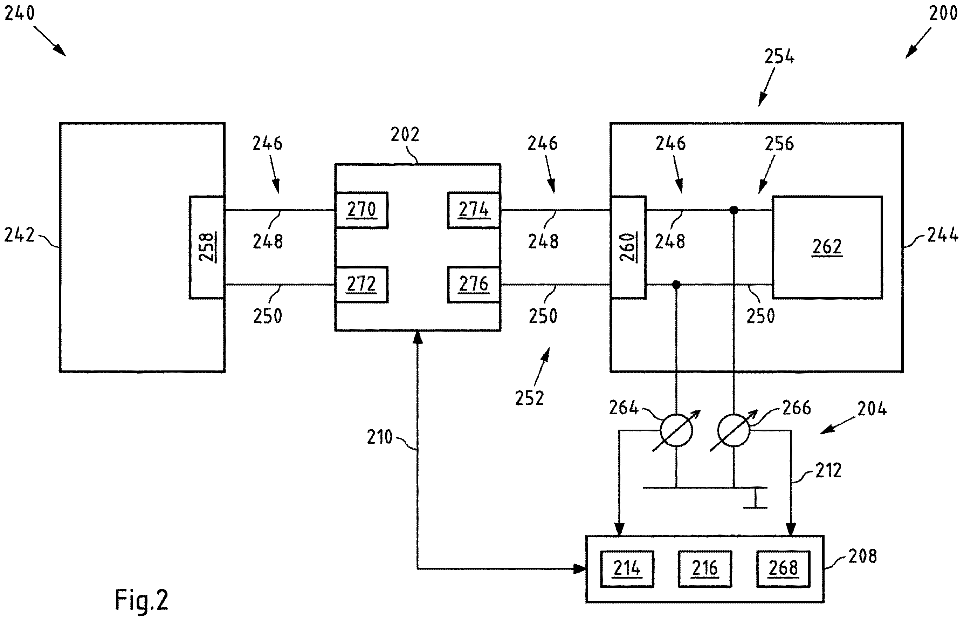

Die Figur 2 zeigt eine schematische Ansicht eines Ausführungsbeispiels eines Systems 240 gemäß der vorliegenden Anmeldung mit einem Ausführungsbeispiel einer Prüfschaltungsanordnung 200 gemäß der vorliegenden Anmeldung. Zur Vermeidung von Wiederholungen werden nachfolgend im Wesentlichen nur die Unterschiede zu dem vorherigen Ausführungsbeispiel beschrieben und ansonsten auf die Ausführungen zur Figur 1 verwiesen.

Das System 240 umfasst eine erste Vorrichtung 242 und eine zweite Vorrichtung 244. Die erste Vorrichtung 242 kann beispielsweise ein erstes Stellwerk sein und die zweite Vorrichtung 244 ein zweites Stellwerk. Zwischen der ersten Vorrichtung 242 und der zweiten Vorrichtung 244 ist ein Antivalenz-Übertragungspfad 246 angeordnet. Wie zu erkennen ist, weist der Antivalenz-Übertragungspfad 246 einen ersten Übertragungsweg 248 (insbesondere gebildet durch mindestens einen elektrischen Leiter bzw. Signalleiter, wie ein Signaldraht) und einen zweiten Übertragungsweg 250 (insbesondere gebildet durch mindestens einen elektrischen Leiter bzw. Signalleiter, wie ein Signaldraht) auf.

Der Antivalenz-Übertragungspfad 246 ist eingerichtet zum Übertragen eines antivalenten Signalbilds. Beispielsweise können die antivalenten Signalbilder (1,0) und (0,1) oder (High,Low) und (Low,High) über den Antivalenz-Übertragungspfad 246 übertragen werden. Wenn die erste Vorrichtung 242 das Signalbild (1,0) aussendet, kann beispielsweise eine logische 1 (z.B. in Form eines ersten definierten Spannungswerts (z.B. 5 Volt)) über den ersten Übertragungsweg 248 und gleichzeitig eine logische 0 (z.B. in Form eines zweiten definierten Spannungswerts (z.B. 0,5 Volt)) über den zweiten Übertragungsweg 250 übertragen werden. Bei dem Signalbild (0,1) kann entsprechend eine logische 0 über den ersten Übertragungsweg 248 und gleichzeitig eine logische 1 über den zweiten Übertragungsweg 250 übertragen werden.

Die erste Vorrichtung 242 kann eine erste (nicht gezeigte) Antivalenzschaltung umfassen, eingerichtet zum Generieren eines antivalenten Signalbilds aus einem zu übertragenen Signalwerts, basierend auf einem vorgegebenen Codierschema. Die zweite Vorrichtung (insbesondere die Verarbeitungseinrichtung) kann eine zweite (nicht gezeigte) Antivalenzschaltung umfassen, eingerichtet zum Detektieren des übertragenen Signalwerts aus dem empfangenen antivalenten Signalbilds, basierend auf einem vorgegebenen und zu dem Codierschema korrespondierenden Decodierschema.

Wie zu erkennen ist, kann vorzugsweise die Signalbildwechselschaltung 202 in einem ersten zwischen einem Signalausgang 258 der ersten Vorrichtung 242 und einem Signaleingang 260 der zweiten Vorrichtung 244 verlaufenden Antivalenz-Übertragungspfadabschnitt 252 angeordnet sein. Der Kopplungsbereich 256 kann in einem zweiten zwischen dem Signaleingang 260 der zweiten Vorrichtung 244 und einer Verarbeitungseinrichtung 262 der zweiten Vorrichtung 244 verlaufenden Antivalenz-Übertragungspfadabschnitt 254 angeordnet sein.

Gemäß der dargestellten bevorzugten Ausführungsform umfasst die Signalsensoreinrichtung 204 einen ersten mit dem ersten Übertragungsweg 248 des Antivalenz-Übertragungspfads 246 gekoppelten Signalsensor 266 und einen zweiten mit dem zweiten Übertragungsweg 250 des Antivalenz-Übertragungspfads 246 gekoppelten Signalsensor 264. Insbesondere können der erste und der zweite Signalsensor 264, 266 jeweils Optokoppler sein, die das Anliegen einer ersten bzw. einer zweiten Signalspannung auf dem ersten bzw. zweiten Übertragungsweg 248, 250 gegen einen gemeinsames Bezugspotential messen, wie ein gemeinsamer Nullleiter. Die erfassten Signalspannungen, aus denen das empfangene bzw. übertragene Signalbild bestimmt werden kann, können der Auswerteeinrichtung 208 über die weitere Verbindung 212 bereitgestellt werden.

Die Auswerteeinrichtung 208 umfasst vorliegend neben der Signalbildwechselsteuerung 214 und dem Prüfmodul 216 ein Schaltzustandsbestimmungsmodul 268. Das Schaltzustandsbestimmungsmodul 268 kann eingerichtet sein zum Bestimmen des augenblicklichen Schaltzustands der Signalbildwechselschaltung 202, basierend auf einem von der Signalbildwechselschaltung 202 (insbesondere über die erste Verbindung 210) empfangbaren und/oder auslesbaren Schaltzustandsdatum. Insbesondere ist das Schaltzustandsdatum ein Signal, wobei das Schaltzustandsdatum ein erstes Signal ist, wenn sich die Signalbildwechselschaltung 202 in dem ersten Schaltzustand befindet, und das Schaltzustandsdatum ein zweites sich von dem ersten Signal unterscheidendes Signal ist, wenn sich die Signalbildwechselschaltung 202 in dem zweiten Schaltzustand befindet. Das Prüfmodul 216 kann eingerichtet sein zum Prüfen der Funktionsfähigkeit des Systems 240 während der Prüfphase, basierend auf dem mindestens einen Schaltbefehl, dem mindestens einen durch die Signalsensoreinrichtung 204 erfassten Signalbild und dem tatsächlichen Schaltzustand.

Bevorzugt kann die Signalbildwechselschaltung 202 eine ansteuerbare Schaltbrücke sein. Die die Signalbildwechselschaltung 202 kann eingerichtet sein, zwischen wenigstens dem ersten Schaltzustand und dem zweiten Schaltzustand umzuschalten. In dem ersten Schaltzustand kann ein erstes Teilsignal des Signalbilds, das über den ersten Übertragungsweg 248 übertragen wird und insbesondere als erstes Eingangssignal an einem ersten Eingang 270 der Signalbildwechselschaltung 202 empfangen wird, über einen ersten Ausgang 274 der Signalbildwechselschaltung 202 als erstes Ausgangssignal über den ersten Übertragungsweg 248 an die zweite Vorrichtung 244 weitergeleitet werden. In dem ersten Schaltzustand kann ein zweites Teilsignal des Signalbilds, das über den zweiten Übertragungsweg 250 übertragen wird und insbesondere als zweites Eingangssignal an einem zweiten Eingang 272 der Signalbildwechselschaltung 202 empfangen wird, über einen zweiten Ausgang 276 der Signalbildwechselschaltung 202 als zweites Ausgangssignal über den zweiten Übertragungsweg 250 an die zweite Vorrichtung 244 weitergeleitet werden.

In dem zweiten Schaltzustand kann das erste Teilsignal des Signalbilds, das über den ersten Übertragungsweg 248 übertragen wird und insbesondere als erstes Eingangssignal an einem ersten Eingang 270 der Signalbildwechselschaltung 202 empfangen wird, über den zweiten Ausgang 276 der Signalbildwechselschaltung 202 als erstes Ausgangssignal über den zweiten Übertragungsweg 250 an die zweite Vorrichtung 244 weitergeleitet werden. In dem zweiten Schaltzustand kann das zweite Teilsignal des Signalbilds, das über den zweiten Übertragungsweg 250 übertragen wird und insbesondere als zweites Eingangssignal an einem zweiten Eingang 272 der Signalbildwechselschaltung 202 empfangen wird, über den ersten Ausgang 274 der Signalbildwechselschaltung 202 als zweites Ausgangssignal über den ersten Übertragungsweg 248 an die zweite Vorrichtung 244 weitergeleitet werden.

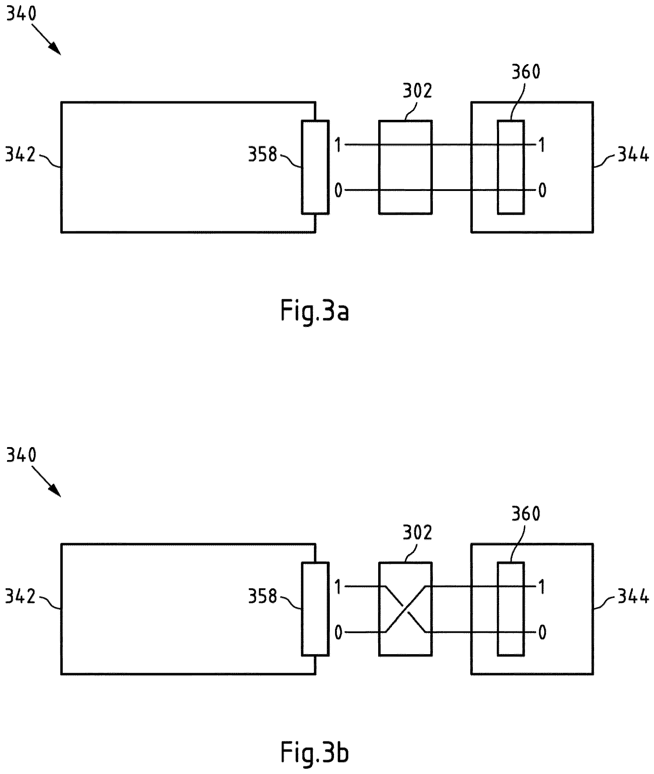

Die Figuren 3a und 3b zeigen schematische Ansichten eines Ausführungsbeispiels eines Systems 340 gemäß der vorliegenden Anmeldung mit einer Signalbildwechselschaltung 302 in einem ersten Schaltzustand bzw. in einem zweiten Schaltzustand. Es sei angemerkt, dass lediglich zu Gunsten einer besseren Übersicht vorliegend auf die Darstellung von Details des Systems 340 (z.B. Auswerteeinrichtung, Signalsensoreinrichtung etc.) verzichtet wurde und die Figuren 3a und 3b insbesondere der Veranschaulichung einer fehlerfreien Funktionsweise des Systems 340 dienen.

Wie bereits beschrieben wurde, kann bei einem Durchlaufen einer Prüfung das zu prüfende System, insbesondere die zweite Vorrichtung 344, in einen Prüfmodus versetzt und die Signalbildwechselschaltung 302 während der Prüfphase, z.B. entsprechend einem vorgegebenen Prüfschema, von einem ersten Schaltzustand in den zweiten Schaltzustand und wieder zurückgeschaltet werden. Die beiden Schaltzustände der Signalbildwechselschaltung 302 und das jeweils durch eine Signalsensoreinrichtung detektierte Eingangssignalbild der zweiten Vorrichtung 342 werden dann in Zusammenhang gebracht und ausgewertet.

Bei einem Wechsel des Schaltzustands der Signalbildwechselschaltung 302 müssen auch die beiden Teilsignale, die der zweiten Vorrichtung 344 zugeführt werden, wechseln, anderenfalls wird ein Fehler im Signaleingang 360 der zweiten Vorrichtung 344 erkannt. Im vorliegenden Beispiel nach Figur 3a sendet die erste Vorrichtung 342 über den Signalausgang das Signalbild (1,0) aus, das der zweiten Vorrichtung 344 unverändert zugeführt wird, wenn sich die Signalbildwechselschaltung 302 im ersten Schaltzustand befindet. Im vorliegenden Beispiel nach Figur 3b sendet die erste Vorrichtung 342 über den Signalausgang weiterhin das Signalbild (1,0) aus, das der zweiten Vorrichtung 344 invertiert, also als Signalbild (0,1), zugeführt wird, wenn sich die Signalbildwechselschaltung 302 im zweiten Schaltzustand befindet. Bei einer vorbeschriebenen Prüfung stellt das Prüfmodul als Prüfergebnis fest, dass die Funktionsweise des Systems 340 fehlerfrei ist.

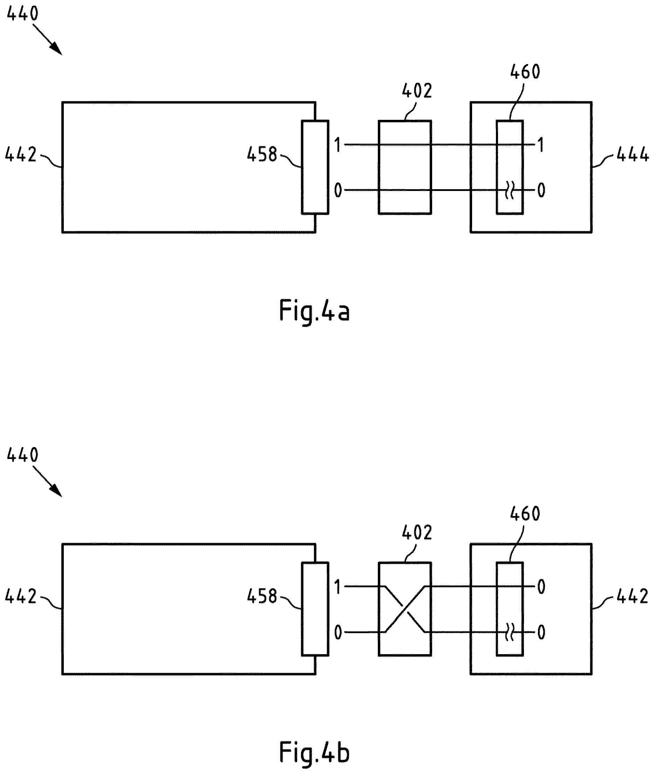

Die Figuren 4a und 4b zeigen schematische Ansichten eines Ausführungsbeispiels eines Systems 440 gemäß der vorliegenden Anmeldung mit einer Signalbildwechselschaltung 402 in einem ersten Schaltzustand bzw. in einem zweiten Schaltzustand. Es sei angemerkt, dass lediglich zu Gunsten einer besseren Übersicht vorliegend auf die Darstellung von Details des Systems 440 (z.B. Auswerteeinrichtung, Signalsensoreinrichtung etc.) verzichtet wurde und die Figuren 4a und 4b insbesondere der Veranschaulichung einer fehlerhaften Funktionsweise des Systems 440 dienen. Beispielhaft und wie schematisch in den Figuren 4a und 4b angedeutet, wird vorliegend als Fehler eine Unterbrechung einer der Übertragungswege bzw. Signalleitungen angenommen, der erst erkannt werden kann durch ein Umschalten der Signalbildwechselschaltung 402 in den zweiten Schaltzustand.

Im vorliegenden Beispiel nach Figur 4a sendet die erste Vorrichtung 442 über den Signalausgang das Signalbild (1,0) aus, das der zweiten Vorrichtung 444 unverändert zugeführt wird, wenn sich die Signalbildwechselschaltung 402 im ersten Schaltzustand befindet. Der Fehler bleibt demnach verborgen. Nur durch einen Signalbildwechsel kann der Fehler detektiert werden. Im vorliegenden Beispiel nach Figur 4b sendet die erste Vorrichtung 442 weiterhin über den Signalausgang das Signalbild (1,0) aus, das der zweiten Vorrichtung 444 invertiert, also als Signalbild (0,1), zugeführt wird, wenn sich die Signalbildwechselschaltung 402 im zweiten Schaltzustand befindet. Aufgrund des Fehlers ist jedoch der zweite Übertragungsweg unterbrochen. Eine Signalsensoreinrichtung erfasst insbesondere das Signalbild (0,0). Bei einer vorbeschriebenen Prüfung stellt das Prüfmodul als Prüfergebnis fest, dass die Funktionsweise des Systems 440 fehlerhaft ist.

Liegt der Fehler hingegen im anderen Übertragungsweg, kann im ersten Schaltzustand der Fehler als (nicht-antivalentes) Signalbild (0,0) erfasst werden. Bei einer vorbeschriebenen Prüfung stellt das Prüfmodul als Prüfergebnis fest, dass die Funktionsweise des Systems 440 fehlerhaft ist.

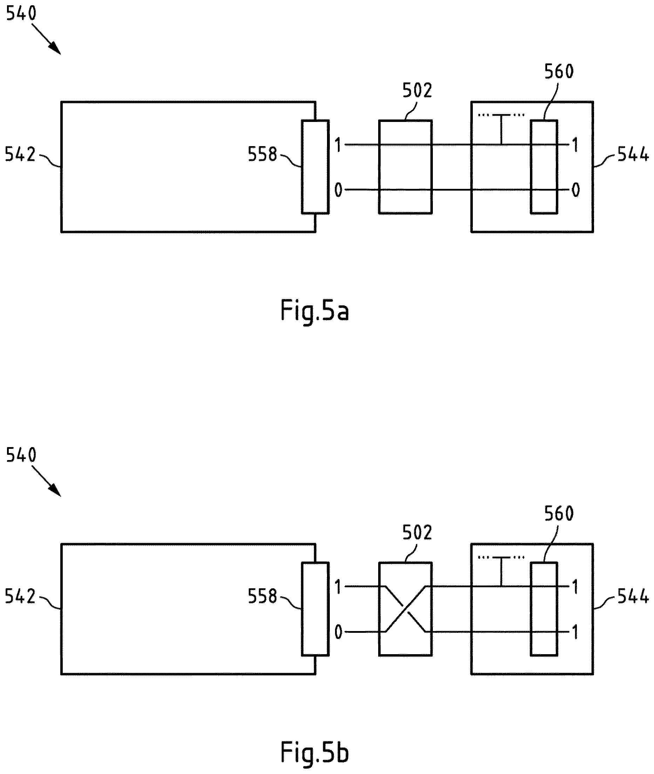

Die Figuren 5a und 5b zeigen schematische Ansichten eines Ausführungsbeispiels eines Systems 540 gemäß der vorliegenden Anmeldung mit einer Signalbildwechselschaltung 502 in einem ersten Schaltzustand bzw. in einem zweiten Schaltzustand. Es sei angemerkt, dass lediglich zu Gunsten einer besseren Übersicht vorliegend auf die Darstellung von Details des Systems 540 (z.B. Auswerteeinrichtung, Signalsensoreinrichtung etc.) verzichtet wurde und die Figuren 5a und 5b insbesondere der Veranschaulichung einer fehlerhaften Funktionsweise des Systems 540 dienen. Beispielhaft und wie schematisch in den Figuren 5a, 5b angedeutet wird vorliegend als Fehler ein Kurzschluss eines Übertragungswegs in einem Signaleingang 560 der zweiten Vorrichtung 544 zu einer weiteren potentialführenden Leitung angenommen, der erst erkannt werden kann durch ein Umschalten der Signalbildwechselschaltung 502 in den zweiten Schaltzustand.

Im vorliegenden Beispiel nach Figur 5a sendet die erste Vorrichtung 542 über den Signalausgang das Signalbild (1,0) aus, das der zweiten Vorrichtung 544 unverändert zugeführt wird, wenn sich die Signalbildwechselschaltung 502 im ersten Schaltzustand befindet. Der Fehler bleibt demnach verborgen. Nur durch einen Signalbildwechsel kann der Fehler detektiert werden. Im vorliegenden Beispiel nach Figur 5b sendet die erste Vorrichtung 542 weiterhin über den Signalausgang das Signalbild (1,0) aus, das der zweiten Vorrichtung 544 invertiert, also als Signalbild (0,1), zugeführt wird, wenn sich die Signalbildwechselschaltung 502 im zweiten Schaltzustand befindet. Aufgrund des Fehlers ist jedoch der erste Übertragungsweg unverändert auf einem weiteren Potential. Eine Signalsensoreinrichtung erfasst insbesondere das Signalbild (1,1). Bei einer vorbeschriebenen Prüfung stellt das Prüfmodul als Prüfergebnis fest, dass die Funktionsweise des Systems 540 fehlerhaft ist.

Ein weiterer Fehler im Signaleingang der zweiten Vorrichtung kann beispielsweise vorliegen durch einen Kurzschluss zwischen den beiden Übertragungswegen, der in beiden Schaltzuständen zu einem regulär nicht erwarteten Signalbild führt, nämlich (1,1), obwohl bekannt ist, dass das Signalbild antivalent sein muss. Bei einer vorbeschriebenen Prüfung stellt das Prüfmodul als Prüfergebnis fest, dass die Funktionsweise des Systems 540 fehlerhaft ist.

Ferner ist es denkbar, dass bereits das Ausgangssignalbild der ersten Vorrichtung nicht regelkonform ist. Aber auch in diesem Fall kann anhand eines nicht-antivalenten Signalbildes auf einen Fehler geschlossen werden, der in einem vorgelagerten Abschnitt der Signalverarbeitungskette aufgetreten ist.

**Tabelle 1**

| **Das durch die Signalsensoreinrichtung erfasste Signalbild** | | **Diagnose bzw. Prüfergebnis** |
|---|---|---|
| **erster Schaltzustand** | **zweiter Schaltzustand** | |
| (1,0) | (0,1) | fehlerfrei |
| (0,1) | (1,0) | fehlerfrei |
| (0,0) | (0,1) oder (1,0) | fehlerhaft (z.B. Unterbrechung in Übertragungsweg mit Teilsignal 1) |
| (0,1) oder (1,0) | (0,0) | fehlerhaft (z.B. Unterbrechung in Übertragungsweg mit Teilsignal 0) |
| (0,1) oder (1,0) | (1,1) | fehlerhaft (z.B. Kurzschluss in Übertragungsweg mit Teilsignal 1) |
| (1,1) | (1,1) | Unzulässiges Eingangssignal oder fehlerhaft (Kurzschluss zwischen den beiden Übertragungswegen) |

Die Tabelle 1 zeigt beispielhaft verschiedene erfassbare Signalbilder bei unterschiedlichen Schaltzuständen und die resultierenden Prüfergebnisse.

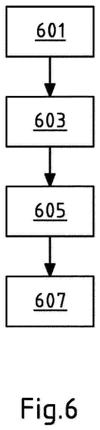

Die Figur 6 zeigt ein Diagramm eines Ausführungsbeispiels eines Verfahren zum Prüfen der Funktionsfähigkeit eines Systems, insbesondere eines Systems nach einem der vorherigen Figuren, wobei das System einen zwischen einer ersten Vorrichtung des Systems und einer zweiten Vorrichtung des Systems angeordneten Antivalenz-Übertragungspfad mit einem ersten Übertragungsweg und einem zweiten Übertragungsweg umfasst, wobei der Antivalenz-Übertragungspfad eingerichtet ist zum Übertragen eines antivalenten Signalbilds von der ersten Vorrichtung zu der zweiten Vorrichtung.

In einem ersten Schritt 601 erfolgt ein Ansteuern einer in dem Antivalenz-Übertragungspfad angeordneten Signalbildwechselschaltung mit mindestens einem Schaltbefehl, wie beschrieben wurde.

In einem (im Wesentlichen parallel durchgeführten) Schritt 603 erfolgt ein Erfassen, durch eine mit einem in Übertragungsrichtung hinter der Signalbildwechselschaltung angeordneten Kopplungsbereich des Antivalenz-Übertragungspfads gekoppelte Signalsensoreinrichtung, eines Signalbilds, wie beschrieben wurde.

In einem Schritt 605 erfolgt ein Prüfen der Funktionsfähigkeit des Systems während einer Prüfphase, basierend auf dem mindestens einen Schaltbefehl und dem mindestens einen durch die Signalsensoreinrichtung erfassten Signalbild, wie beschrieben wurde.

In einem optionalen Schritt 607 erfolgt ein Ausgeben des Prüfergebnisses, wie bereits beschrieben wurde.

### Bezugszeichenliste:

- 100: Prüfschaltungsanordnung
- 102: Signalbildwechselschaltung
- 104: Signalsensoreinrichtung
- 106: Koppelverbindung
- 108: Auswerteeinrichtung
- 110: erste Verbindung
- 112: weitere Verbindung
- 114: Signalbildwechselsteuerung
- 116: Prüfmodul
- 118: Datenspeicher
- 120: erstes Ausgabemodul
- 122: zweites Ausgabemodul
- 124: Detektionsmodul
- 126: Prüfmoduseinstellmodul
- 128: Empfänger
- 130: Schalter
- 200: Prüfschaltungsanordnung
- 202: Signalbildwechselschaltung
- 204: Signalsensoreinrichtung
- 208: Auswerteeinrichtung
- 210: erste Verbindung
- 212: weitere Verbindung
- 214: Signalbildwechselsteuerung
- 216: Prüfmodul
- 240: System
- 242: erste Vorrichtung
- 244: zweite Vorrichtung
- 246: Antivalenz-Übertragungspfads
- 248: erster Übertragungsweg
- 250: zweiter Übertragungsweg
- 252: erster Übertragungspfadabschnitt
- 254: zweiter Übertragungspfadabschnitt
- 256: Kopplungsbereich
- 258: Signalausgang
- 260: Signaleingang
- 262: Verarbeitungseinrichtung
- 264: zweiter Signalsensor
- 266: erster Signalsensor
- 268: Schaltzustandsbestimmungsmodul
- 270: erster Eingang
- 272: zweiter Eingang
- 274: erster Ausgang
- 276: zweiter Ausgang
- 302: Signalbildwechselschaltung
- 340: System
- 342: erste Vorrichtung
- 344: zweite Vorrichtung
- 358: Signalausgang
- 360: Signaleingang
- 402: Signalbildwechselschaltung
- 440: System
- 442: erste Vorrichtung
- 444: zweite Vorrichtung
- 458: Signalausgang
- 460: Signaleingang
- 502: Signalbildwechselschaltung
- 540: System
- 542: erste Vorrichtung
- 544: zweite Vorrichtung
- 558: Signalausgang
- 560: Signaleingang

## Patentansprüche

1. Prüfschaltungsanordnung (100, 200) für ein System (240, 340, 440, 540) mit einem zwischen einer ersten Vorrichtung (242, 342, 442, 542) des Systems (240, 340, 440, 540) und einer zweiten Vorrichtung (244, 344, 444, 544) des Systems (240, 340, 440, 540) angeordneten Antivalenz-Übertragungspfad (246) mit einem ersten Übertragungsweg (248) und einem zweiten Übertragungsweg (250), wobei der Antivalenz-Übertragungspfad (246) eingerichtet ist zum Übertragen eines antivalenten Signalbilds von der ersten Vorrichtung (242, 342, 442, 542) zu der zweiten Vorrichtung (244, 344, 444, 544), umfassend:
- eine in dem Antivalenz-Übertragungspfad (246) anordenbare Signalbildwechselschaltung (102, 202, 302, 402, 502),
- eine mit einem in Übertragungsrichtung hinter der Signalbildwechselschaltung (102, 202, 302, 402, 502) angeordneten Kopplungsbereich (256) des Antivalenz-Übertragungspfads (246) koppelbare Signalsensoreinrichtung (104, 204), und
- eine mit der Signalbildwechselschaltung (102, 202, 302, 402, 502) und der Signalsensoreinrichtung (104, 204) verbundene Auswerteeinrichtung (108, 208),
- wobei die Auswerteeinrichtung (108, 208) eine Signalbildwechselsteuerung (114, 214) umfasst, eingerichtet zum Ansteuern der Signalbildwechselschaltung (102, 202, 302, 402, 502) mit mindestens einem Schaltbefehl während einer Prüfphase,
- wobei die Auswerteeinrichtung (108, 208) ein Prüfmodul (116, 216) umfasst, eingerichtet zum Prüfen der Funktionsfähigkeit des Systems (240, 340, 440, 540) während der Prüfphase, basierend auf dem mindestens einen Schaltbefehl und mindestens einem durch die Signalsensoreinrichtung (104, 204) erfassten Signalbild.

2. Prüfschaltungsanordnung (100, 200) nach Anspruch 1, **dadurch gekennzeichnet, dass**
- die Signalbildwechselschaltung (102, 202, 302, 402, 502) eine Schaltbrücke ist.

3. Prüfschaltungsanordnung (100, 200) nach Anspruch 1 oder 2, **dadurch gekennzeichnet, dass**
- die Signalbildwechselsteuerung (114, 214) eingerichtet ist zum Ansteuern der Signalbildwechselschaltung (102, 202, 302, 402, 502), derart, dass eine durch die erste Vorrichtung (242, 342, 442, 542) bewirkte Signalbildänderung von einem ersten Signalbild zu einem zweiten Signalbild simuliert wird.

4. Prüfschaltungsanordnung (100, 200) nach einem der vorherigen Ansprüche, **dadurch gekennzeichnet, dass**
- die Signalbildwechselsteuerung (114, 214) eingerichtet ist zum Ansteuern der Signalbildwechselschaltung (102, 202, 302, 402, 502) mit dem mindestens einen Schaltbefehl, basierend auf einem vorgegebenen Prüfschema.

5. Prüfschaltungsanordnung (100, 200) nach einem der vorherigen Ansprüche, **dadurch gekennzeichnet, dass**
- die Signalbildwechselschaltung (102, 202, 302, 402, 502) eingerichtet ist zum Umschalten zwischen zumindest einem ersten Schaltzustand und einem zweiten Schaltzustand, basierend auf dem mindestens einen Schaltbefehl,
- wobei in dem ersten Schaltzustand das durch die erste Vorrichtung (242, 342, 442, 542) ausgesendete Signalbild unverändert bleibt, und
- wobei in dem zweiten Schaltzustand das durch die erste Vorrichtung (242, 342, 442, 542) ausgesendete Signalbild durch die Signalbildwechselschaltung (102, 202, 302, 402, 502) invertiert wird.

6. Prüfschaltungsanordnung (100, 200) nach einem der vorherigen Ansprüche, **dadurch gekennzeichnet, dass**
- die Signalbildwechselschaltung (102, 202, 302, 402, 502) in einem ersten zwischen einem Signalausgang (258, 358, 458, 558) der ersten Vorrichtung (242, 342, 442, 542) und einem Signaleingang (260, 360, 460, 560) der zweiten Vorrichtung (244, 344, 444, 544) verlaufenden Antivalenz-Übertragungspfadabschnitt (252) anordenbar ist, und
- der Kopplungsbereich (256) in einem zweiten zwischen dem Signaleingang (260, 360, 460, 560) der zweiten Vorrichtung (244, 344, 444, 544) und einer Verarbeitungseinrichtung (262) der zweiten Vorrichtung (244, 344, 444, 544) verlaufenden Antivalenz-Übertragungspfadabschnitt (254) angeordnet ist.

7. Prüfschaltungsanordnung (100, 200) nach einem der vorherigen Ansprüche, **dadurch gekennzeichnet, dass**
- die Signalsensoreinrichtung (104, 204) einen ersten mit dem ersten Übertragungsweg (248) des Antivalenz-Übertragungspfads (246) koppelbaren Signalsensor (266) umfasst, und
- die Signalsensoreinrichtung (104, 204) einen zweiten mit dem zweiten Übertragungsweg (250) des Antivalenz-Übertragungspfads (246) koppelbaren Signalsensor (264) umfasst.

8. Prüfschaltungsanordnung (100, 200) nach einem der vorherigen Ansprüche, **dadurch gekennzeichnet, dass**
- das Prüfmodul (116, 216) eingerichtet ist zum Prüfen der Funktionsfähigkeit des Systems (240, 340, 440, 540) während der Prüfphase, basierend auf dem mindestens einen Schaltbefehl, dem mindestens einen durch die Signalsensoreinrichtung (104, 204) erfassten Signalbild und einem vorgegebenen Prüfkriterium.

9. Prüfschaltungsanordnung (100, 200) nach einem der vorherigen Ansprüche, **dadurch gekennzeichnet, dass**
- die Auswerteeinrichtung (108, 208) mindestens ein Schaltzustandsbestimmungsmodul (268) umfasst, eingerichtet zum Bestimmen des augenblicklichen Schaltzustands der Signalbildwechselschaltung (102, 202, 302, 402, 502), basierend auf einem von der Signalbildwechselschaltung empfangbaren und/oder auslesbaren Schaltzustandsdatum.

10. Prüfschaltungsanordnung (100, 200) nach einem der vorherigen Ansprüche, **dadurch gekennzeichnet, dass**
- die Prüfschaltungsanordnung (100, 200) ein Prüfmoduseinstellmodul (126) umfasst, eingerichtet zum Setzen der zweiten Vorrichtung in einen Prüfmodus während der Prüfphase.

11. System (240, 340, 440, 540), umfassend:
- eine erste Vorrichtung (242, 342, 442, 542),
- eine zweite Vorrichtung (244, 344, 444, 544),
- einen zwischen der ersten Vorrichtung (242, 342, 442, 542) und der zweiten Vorrichtung (244, 344, 444, 544) angeordneten Antivalenz-Übertragungspfad (246) mit einem ersten Übertragungsweg (248) und einem zweiten Übertragungsweg (250),
- wobei der Antivalenz-Übertragungspfad (246) eingerichtet ist zum Übertragen eines antivalenten Signalbilds von der ersten Vorrichtung (242, 342, 442, 542) zu der zweiten Vorrichtung (244, 344, 444, 544), und
- mindestens eine Prüfschaltungsanordnung (100, 200) nach einem der vorherigen Ansprüche.

12. System (240, 340, 440, 540) nach Anspruch 11, **dadurch gekennzeichnet, dass**
- die erste Vorrichtung (242, 342, 442, 542) ein erstes Stellwerk ist und die zweite Vorrichtung (244, 344, 444, 544) ein zweites Stellwerk ist.

13. Verfahren zum Prüfen der Funktionsfähigkeit eines Systems (240, 340, 440, 540), insbesondere eines Systems nach Anspruch 11 oder 12, wobei das System (240, 340, 440, 540) einen zwischen einer ersten Vorrichtung (242, 342, 442, 542) des Systems (240, 340, 440, 540) und einer zweiten Vorrichtung (244, 344, 444, 544) des Systems (240, 340, 440, 540) angeordneten Antivalenz-Übertragungspfad (246) mit einem ersten Übertragungsweg (248) und einem zweiten Übertragungsweg (250) umfasst, wobei der Antivalenz-Übertragungspfad (246) eingerichtet ist zum Übertragen eines antivalenten Signalbilds von der ersten Vorrichtung (242, 342, 442, 542) zu der zweiten Vorrichtung (244, 344, 444, 544), wobei das Verfahren umfasst:
- Ansteuern einer in dem Antivalenz-Übertragungspfad (246) angeordneten Signalbildwechselschaltung (102, 202, 302, 402, 502) mit mindestens einem Schaltbefehl,
- Erfassen, durch eine mit einem in Übertragungsrichtung hinter der Signalbildwechselschaltung (102, 202, 302, 402, 502) angeordneten Kopplungsbereich (256) des Antivalenz-Übertragungspfads (246) gekoppelte Signalsensoreinrichtung (104, 204), eines Signalbilds, und
- Prüfen der Funktionsfähigkeit des Systems (240, 340, 440, 540) während einer Prüfphase, basierend auf dem mindestens einen Schaltbefehl und dem mindestens einen durch die Signalsensoreinrichtung (104, 204) erfassten Signalbild.

14. Verwendung einer Prüfschaltungsanordnung nach einem der vorherigen Ansprüche 1 bis 10 zum Prüfen der Funktionsfähigkeit eines Systems (240, 340, 440, 540) mit einem zwischen einer ersten Vorrichtung (242, 342, 442, 542) des Systems (240, 340, 440, 540) und einer zweiten Vorrichtung (244, 344, 444, 544) des Systems (240, 340, 440, 540) angeordneten Antivalenz-Übertragungspfad (246) mit einem ersten Übertragungsweg (248) und einem zweiten Übertragungsweg (250), wobei der Antivalenz-Übertragungspfad (246) eingerichtet ist zum Übertragen eines antivalenten Signalbilds von der ersten Vorrichtung (242, 342, 442, 542) zu der zweiten Vorrichtung (244, 344, 444, 544).
